# EUROPEAN PATENT SPECIFICATION

(11) **EP 0 931 186 B1**
(45) Date of publication and mention of the grant of the patent: **14.04.2004**
(21) Application number: 97944244.9
(22) Date of filing: 25.09.1997
(51) Int. Cl.: C30B 25/14

(54) **A DEVICE FOR EPITAXIALLY GROWING OBJECTS AND METHOD FOR SUCH A GROWTH**
VERFAHREN UND VORRICHTUNG ZUR EPITAKTISCHEM WACHSEN VON OBJEKTEN
DISPOSITIF ET PROCEDE DE FORMATION D'OBJETS PAR EPITAXIE

(30) Priority: 01.10.1996 SE 9603587
(43) Date of publication of application: 28.07.1999
(73) Proprietor: OKMETIC OYJ, 01301 Vantaa (FI)
(72) Inventor: KORDINA, Olle, S-590 52 Sturefors (SE); ELLISON, Alex, S-582 53 Linköping (SE); GU, Chun-Yuan, S-722 46 Väster s (SE); JANZ N, Erik, S-590 30 Borensberg (SE); HALLIN, Christer, S-583 31 Linköping (SE); TUOMINEN, Marko, S-582 51 Linköping (SE)
(74) Representative: Egeröd, Lisbeth
(86) International application number: PCT/SE1997/001612
(87) International publication number: WO 1998/014643

(56) References cited:
- EP-A- 0 045 599
- WO-A-97/01658
- US-A- 5 204 314
- PATENT ABSTRACTS OF JAPAN, Vol. 17, No. 321; & JP,A,05 032 484 (ULVAC JAPAN LTD), 9 February 1993.

## Description

### TECHNICAL FIELD OF THE INVENTION AND PRIOR ART

The present invention relates to a device for epitaxially growing objects of one of a) SiC, b) a Group III-nitride and c) alloys thereof by Chemical Vapour Deposition on a substrate comprising a susceptor having circumferential walls surrounding a room for receiving the substrate, means for feeding a flow of at least a carrier gas and reactive gases needed for the growth into the susceptor towards the substrate and means for heating said circumferential walls and by that the substrate and said reactive gases above a temperature level from which the reactive gases start to decompose into substances depositing on the substrate for the growth of a said object, said feeding means comprising a conduit emerging into said room, as well as a method for epitaxially growing such objects according to the preamble of the appended independent method claim.

Accordingly, the invention is applicable to the growth of SiC, Group III-nitrides and alloys thereof, but the common problem when such objects are to be grown of a high crystalline quality and at a reasonable growth rate from the commercial point of view will now by way of a non-limitative example be further explained for SiC.

When SiC single crystals are grown at such a reasonable growth rate the temperature at which the substrate and said reactive gases, e.g. silane and propane, is heated has to be rather high, and preferably is the so called High Temperature Chemical Vapour Deposition (HTCVD) technique, which is described in the US patent 5 704 985 (corresponding to the Swedish patent application 9502288-5) by the present applicant, used. Such high temperatures do however cause a premature decomposition of the reactive gases, especially silane in said conduit near the inlet thereof in said room in a device defined above and described in for example said US patent 5 704 985. Such a premature decomposition causes a plugging of said conduit after some time, so that the growth has to be interrupted earlier than desired. Furthermore, there will be irregularities in the flow of said reactive gases towards the substrate when the cross-section of the free passage of said conduit is gradually reduced during the growth.

### SUMMARY OF THE INVENTION

The object of the present invention is to advise a solution to the problem discussed above by providing a device and method making it possible to epitaxially grow objects of SiC, a Group III-nitride or alloys thereof at a high growth rate while still obtaining a high crystalline quality of the object grown and be able to carry out the growth until an object of the size desired has been grown.

This object is in accordance with the invention obtained by providing a device defined in the introduction with feeding means further comprising an additional second conduit received in the first-mentioned first conduit, having a smaller cross-section than the first conduit and extending in the longitudinal direction of the first conduit with a circumferential space separating it from inner walls of the first conduit, said feeding means is adapted to make the first conduit to conduct substantially only a carrier gas and the second conduit to conduct substantially the entire flow of reactive gases, and the second conduit ends, as seen in the direction of said flows, and emerges into said first conduit at a distance from said room. This distance is chosen so that said reactive gases will not reach such a high temperature inside the second conduit that they will decompose therein. Thus, the reactive gases are separated from the main flow of the carrier gas (said second conduit may also conduct smaller amounts of carrier gas for increasing the velocity of the flow therein). Due to the fact that said second conduit ends at a distance from said room it will not get so hot that there will be any risk of decomposition of reactive gases therein, and plugging of said second conduit. Furthermore, the flow of reactive gases emerging from said second conduit will thanks to said circumferential space be surrounded in the critical plugging zone by the carrier gas flow in said conduit and it will tend to continue moving straight on as if the second conduit would still be there without any substantial intermixing with the carrier gas flow. Accordingly, the carrier gas flow will at least partially thermally insulate the flow of reactive gases from the hot wall of the first conduit, so that the temperature will be lower in that part of the first conduit where the reactive gases flow. This fact will counteract premature decomposition of the reactive gases in said first conduit before the inlet thereof into said room, and if such decomposition would after all occur the decomposed gases have a long way to diffuse through the carrier gas flow for reaching the inner wall of the first conduit and will therefore only to a small extent reach said wall, so that plugging of the portion of said first conduit closest to said room is avoided or will in any case result after a much longer time than in prior art devices. Another advantage of this device is that said reactive gases, especially silane in the case of growth of SiC, is not wasted by a considerable decomposition and depositing before entering the susceptor so that a better economy is also achieved in that sense. According a preferred embodiment of the invention the first conduit has a cross-section being enlarged in the region where the second conduit emerges into the first one and decreasing from this region in the direction of said room. This is a very advantageous feature making it possible to remarkably prolong the time the device may be used for growth until a possible plugging of the inlet even if the object is grown at a high growth rate. As mentioned, a fraction of the reactive gases will after all decompose in the first conduit before reaching said room and tend to deposit on the inner walls thereof. Such depositions occur substantially only within a determined temperature range of the reactive gases, which corresponds to the temperature these gases reach nearly directly downstream of their entrance into the first conduit, accordingly in said region, and at the distance downstream thereof they have again exceeded this critical temperature range, so that a deposition ring will be formed in the first conduit in this region. By making the cross-section enlarged in this region and reducing it from this region in the direction of said room, the outer carrier gas flow conducted along the walls of the first conduit will in this region be accelerated as it passes through a portion of this conduit having a decreasing cross-section, so that this flow, when reaching the critical region where parasitic depositions may occur, will force species of the reactive gases back to the centre. The net amount of species from the decomposed reactive gases reaching the heated walls of the first conduit will be decreased. Furthermore, the heating of the inner walls of the first conduit in this region is decreased by a radiation screening effect and by a net decrease of conduction heat transfer per unit volume, since the cross-section of the first conduit will be smaller closer to said room than in said region. Besides that, it will also take a longer time for the first conduit to be plugged simply for the reason that the cross-section thereof is enlarged in said region.

According to another preferred embodiment of the invention said first conduit has inner walls converging from said region. It has been found that this is an appropriate way of obtaining the decreasing cross-section. The walls may converge in any desired way such as linearly, exponentially or according to another function.

According to another preferred embodiment of the invention the first conduit has a cross-section decreasing from said region in the direction of the room to a first location upstream of said room and from said location to the room a substantially constant cross-section, which will reduce the heating of the inner walls of the first conduit upstream of said location by a radiation screening effect and by a net decrease of conduction heat transfer per unit volume.

According to another preferred embodiment of the invention the cross-section of the first conduit increases from a second location downstream of said region and to said room, so that the opening into said room will be shaped as a diffuser and the reactive gases will be spread in a way that under certain circumstances will be desired.

According to another preferred embodiment of the invention it comprises means adapted to cool the inner walls of a first wall portion of said first conduit next to said region upstream thereof, and that wall portions of the first conduit downstream of the first wall portion are made of a material with a thermal conductivity utilizing heat transfer from the heated susceptor for obtaining a temperature gradient along walls of the first conduit in said region being as steep as possible. This means that the temperature gradient in the first conduit will be very steep in said region, which means that the reactive gases are violently heated when emerging from the inner second conduit and will by that be accelerated by free convection and pass the area critical for parasitic depositions as fast as possible. Furthermore, the presence of a steep temperature gradient allows to define said critical area as just downstream thereof, so that depositions will occur in a wide cross-section part of the first conduit, where it is harmless, and not in the end of the conduit part with decreasing cross-section, where it would lead to a rapid blocking.

According to another preferred embodiment of the invention said first and second conduits are concentrically arranged with respect to each other at least close to said room. Such a mutual arrangement of the two conduits is advantageous, since the shortest distance between said second conduit and inner walls of the first conduit will then be a maximum and by that the advantage of the invention mentioned above will then be as great as possible.

According to another preferred embodiment of the invention said conduits have a substantially vertical extension, a substantially vertical wall of said room is adapted to carry said substrate, and said room has a gas outlet arranged in the ceiling thereof substantially opposite to the inlet. By forming such a so-called chimney reactor configuration a good quality growth has been obtainable. This configuration of the device also makes it possible to arrange a plurality of substrates for growth of object thereon on the substantially vertical walls of said room, so that the growth capacity is multiplied, and higher growth rates may also be obtained due to a geometry suitable for higher temperatures with low carrier gas flows.

According to another preferred embodiment of the invention the device is adapted for growth of objects of SiC, and said heating means is arranged to heat the reactive gases so that the temperature thereof rises above 500°C after entering the first conduit but before entering the room. This is advantageous, since the reactive gases, especially silane, when it is used, will start to decompose at 500°C, and it has to be avoided that this takes place in the second conduit. However, it is impossible to avoid that this happens before the reactive gases reach the room, since otherwise the temperature in said room would be much too low for obtaining a high growth rate. According to another preferred embodiment constituting a further development of the embodiment last mentioned said heating means is arranged to heat the reactive gases so that the temperature thereof rises above 500°C in the portion of the first conduit with a decreasing cross-section in the most upstream part of this portion. This is very preferred, since the deposition ring formed primarily by Si species will by this be located where the cross-section is very wide and a possible blocking of the conduit will take a very long time.

A method according to the invention and preferred embodiments thereof are defined in the appended method claims, and the advantages of the characteristics of these claims appear from the discussion above, and it is here only added, that in a preferred embodiment the carrier gas is fed in said first conduit with substantially the same velocity as that of the flow of reactive gases in said second conduit, and it has turned out that the choice of substantially the same velocity of both flows will lead to an optimum result with a minimum of intermixing of the two flows beyond said end of said second conduit, so that the reactive gases will move on in the prolongation of the said second conduit surrounded by the carrier gas flow substantially without any contents of reactive gases.

Further preferred features and advantages of the device and method according to the invention will appear from the following description and the other dependent claims.

### BRIEF DESCRIPTION OF THE DRAWINGS

With reference to the appended drawings below follows a specific description of preferred embodiments of the invention cited as examples.

In the drawings:
- Fig. 1: is a longitudinal cross-section view of a prior art device of the type described in the US patent 5 704 985 for the growth of objects by Chemical Vapour Deposition,
- Fig. 2: is an enlarged view of the gas inlet part of the susceptor in a device of the type shown in Fig. 1 according to a first preferred embodiment of the invention,
- Fig. 3: is a view being enlarged with respect to Fig. 2 of the region where the second conduit emerges into the first one of the gas inlet part of Fig. 2,
- Fig. 4: is a view corresponding to Fig. 3 of the gas inlet part of a device according to a second preferred embodiment of the invention,
- Fig. 5: is a sectioned view of a device according to a third preferred embodiment of the invention,
- Fig. 6: is a view corresponding to Fig. 3 and 4 of the gas inlet part of the susceptor in a device of a fourth preferred embodiment of the invention, and
- Fig. 7: is a simplified view of a device according to a fifth preferred embodiment of the invention.

### DETAILED DESCRIPTION OF A PREFERRED EMBODIMENT OF THE INVENTION

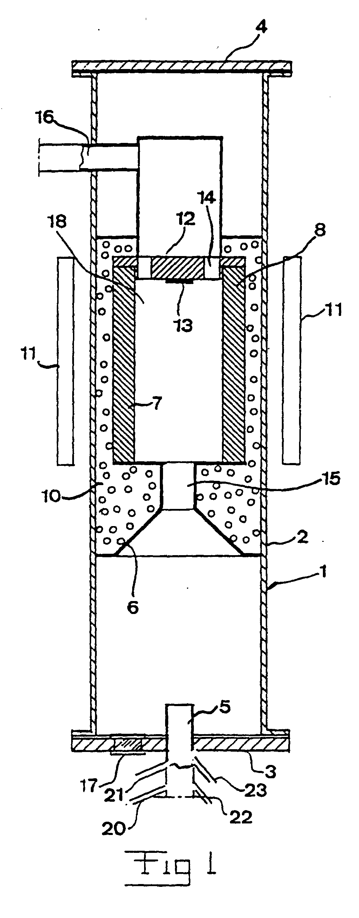

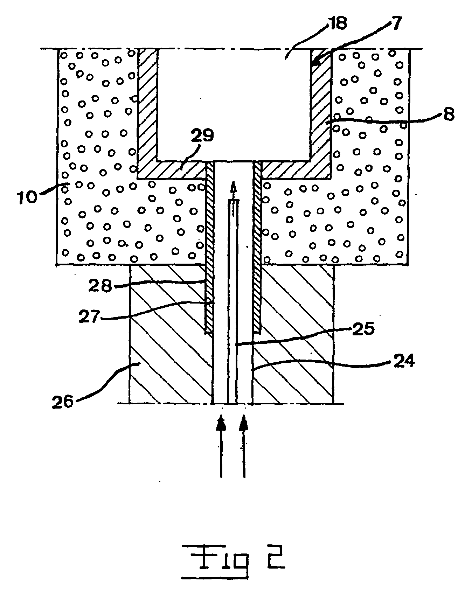

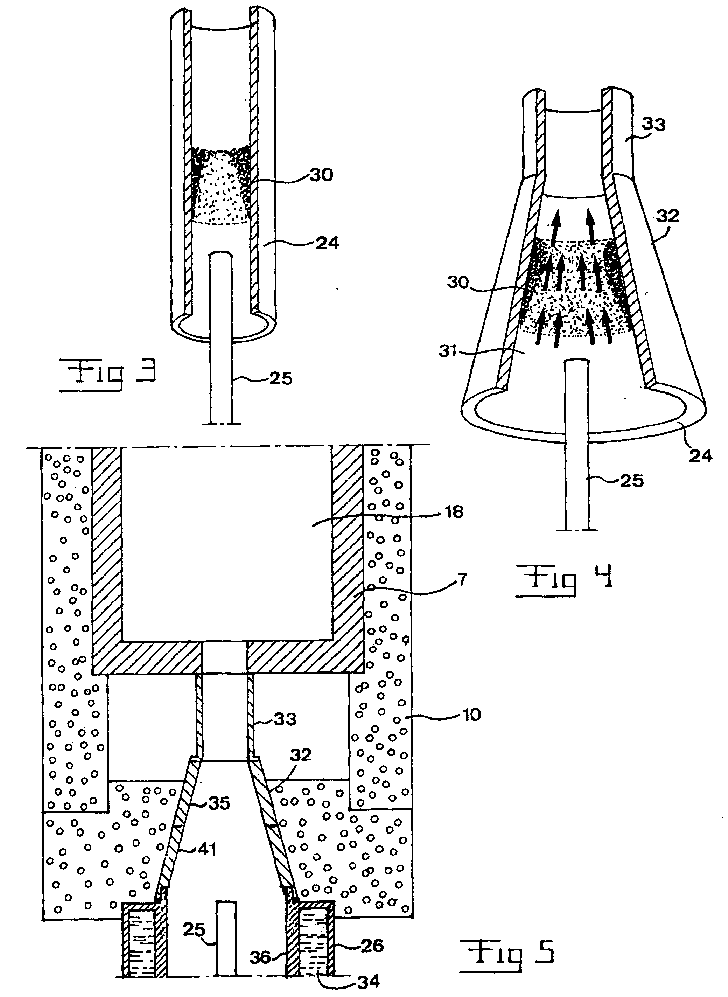

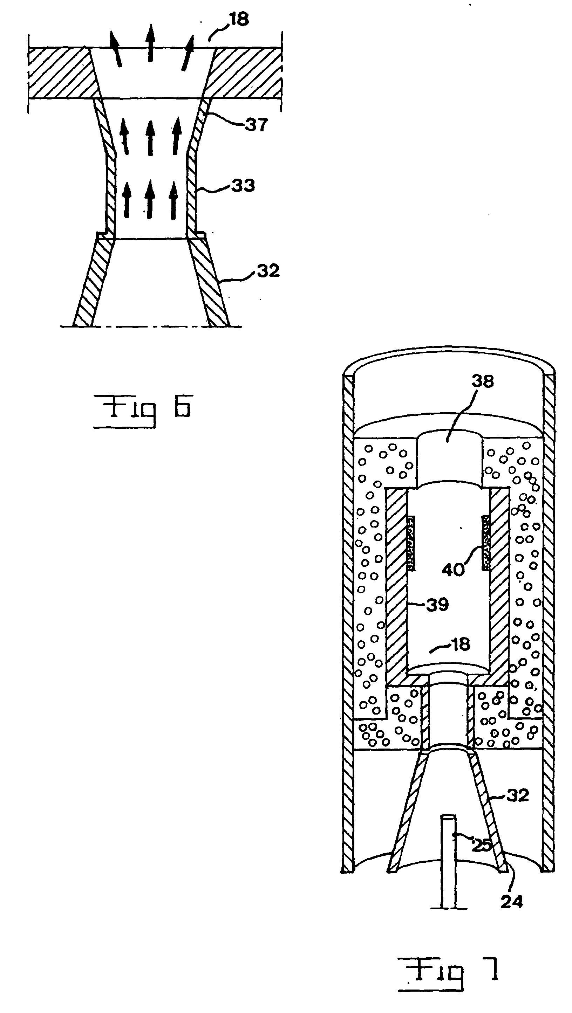

Fig. 1 shows schematically a device of the type described in the US patent 5 704 985, but it will still be described here, since the device according to the invention may have the same principle construction as that device and only differ therefrom by the particular characteristics defined in the present invention. This device is suited for epitaxially growing SiC by Chemical Vapour Deposition on a SiC substrate. The device is shown in a simplified manner, and it is obvious that the device in question also comprises other means, such as pumps, but conventional equipment having nothing to do with the inventional problem has been omitted for the sake of clearness and concentration to the invention.

This device comprises a casing 1 constituted by a tube 2 of quartz extending substantially vertically and two opposite end flanges 3 and 4. The end flange 4 is preferably removable so as to get access to the interior of the tube 2. A conduit 5 for supplying a flow of a carrier gas and reactive gases, preferably silane and propane, for said growth to the substrate is introduced through the lower end flange 3. The conduit 5 is connected to separate conduits 20-23 leading to sources for different gases for said growth, such as silane and propane, and said carrier gas, and these conduits are provided with flow regulating means not shown for regulating the content of each component in the gas flow in the conduit 5. The conduits 20-23 are in Fig. 1 for the sake of clearness illustrated as emerging into the conduit 5 close to the casing 1, but in practise they will probably be at a greater distance therefrom.

Furthermore, the device comprises a funnel 6 for concentrating the gas flow from the conduit 5 into a susceptor 7. The susceptor 7 shown in Fig. 1 is adapted for epitaxially growing layers of SiC. The susceptor is substantially cylindrical with circumferential walls 8 of a substantial uniform thickness. The walls are made of graphite, but they are internally coated by a layer of SiC or alternately covered by a cylindrical plate made of SiC. The space surrounding the susceptor is enclosed and filled by graphite foam 10 for thermal insulation to protect the surrounding quartz tube 2. Rf-field radiating means 11 in form of a Rf-coil surrounds the tube 2 along the longitudinal extension of the susceptor 7. This heating means 11 is arranged to radiate a Rf-field uniformly heating the walls 8 of the susceptor and thereby the gas mixture introduced into the susceptor.

The susceptor 7 comprises a lid 12 of the same material as the rest of the susceptor, on the lower side of which a SiC substrate 13 is arranged and which may be removed from the rest of the susceptor so as to remove the substrate after a layer has been grown thereon. The lid 12 is provided with peripheral gas outlet holes 14, so that a preferably laminar gas flow will enter the susceptor room 18 through a lower inlet conduit 15 and flow close to the substrate and leave the susceptor through the upper outlets 14 and then the device through a conduit 16 possibly optionally connected to a pump not shown.

The temperature inside the susceptor 7 may be checked pyrometrically through looking into the susceptor 7 through a window indicated at 17.

In such a device the heating means 11 will heat the susceptor walls 8 and by that the susceptor room 18 and the substrate 13 and the gases introduced into the susceptor room through the conduit 15, so that the reactive gases will decompose and deposit on the substrate for the growth. However, when high growth rates are desired it is necessary to raise the temperature inside the susceptor to a high level, such as for instance above 2000°C, and it may not be avoided that the temperature in the conduit 15 will be that high that reactive gases, especially silane, will be decomposed already in this conduit and deposited on the inner wall of that conduit, so that the cross-section of the free passage thereof will be reduced and plugging of the conduit will appear a long time before a growth run would otherwise be terminated, so that the growth run has to be interrupted too early.

Fig. 2 illustrates how the inlet side of such a device may be modified according to a preferred embodiment of the invention so as to solve the problem just mentioned. In this device a first conduit 24 emerges into the room 18 of the susceptor 7 and is adapted to conduct substantially only a carrier gas to the susceptor room 18. The definition of carrier gas is a gas not actively participating in the growth, i. e. not having components which are grown into said object of the substrate. This carrier gas may preferably be Argon, Helium or a blend thereof. The device further comprises a second conduit 25 received in the first conduit, having a smaller cross-section than the first conduit and extending in the longitudinal direction of the first conduit with a circumferential space separating it from inner walls of the first conduit.

Furthermore, the second conduit is concentrically arranged with respect to the first conduit. Both conduits are in this case rigid tubes, and the first conduit 24 is made for instance of stainless steel with regard to the portion 26 extending to the outer wall of the susceptor, and this portion 26 is water-cooled. The inner walls of the first conduit 24 closest to said room 18 are made of SiC, dense graphite or pyrolitic graphite by arranging a tube 28 there. The second, inner conduit 25 is preferably made of SiC or other high-temperature resistant materials as Tantalum and Tungsten in order to avoid any contamination of the reactive gases by undesirable impurities.

The second conduit 25 is adapted to conduct substantially the entire flow of reactive gases, but some carrier gas may also be introduced together with these reactive gases, which may be for the silicon precursor, silane or chlorosilanes, and for the carbon precursor, propane, methane or ethylene when SiC is grown, to give them a high velocity depending on the conditions. Doping source gases may also be conducted in the second conduit. Furthermore, and this is an essential feature of the present invention, the second conduit ends, as seen in the direction of said flows, and emerges into said first conduit at a distance from said room 18. This distance is chosen so that said reactive gases will not reach such a high temperature inside the second conduit that they will decompose therein, and the requirement of this distance will accordingly depend upon the temperature that is chosen inside the susceptor room 18 for the growth, the carrier gas flow and which carrier gas is chosen, since the carrier gas may act as a thermal insulator between the walls of the first conduit and the second conduit. More exactly, the second conduit ends comparatively close to said room, here at a short distance from the bottom 29 thereof, but this will be enough for avoiding decomposition of reactive gases in said second conduit.

Accordingly, the reactive gases will emerge into said first conduit without being decomposed and travel in the central part of the first conduit at a distance from the walls thereof, and the carrier gas flow will move in the space between the flow of reactive gases and the inner walls of the first conduit so as if the second conduit 25 would actually continue until the room 18 of the susceptor. It is preferred to control the velocities of the carrier gas flow and the flow in the second conduit so that they are substantially the same for obtaining as little intermixing therebetween as possible. The surrounding carrier gas flow will act as a thermal insulator for the central flow of reactive gases and retard the temperature raise thereof, so that the reactive gases are preferably not decomposed before entering the room 18 of the susceptor. Should this after all occur, the components resulting from a decomposition of reactive gases will only to a small extent reach the wall of the first conduit, since they have to diffuse through the surrounding carrier gas flow all the way to the inner wall of the first conduit for depositing thereon.

It has, however, been found that some of the species resulting from the decomposition of the reactive gases will reach and deposit on the inner wall of the first conduit, and it has moreover been found that such deposition occurs only within a determined temperature range of the reactive gases, namely in the case of growing SiC approximately from 500 to 800°C. Below 500°C SiH₄ will not be decomposed and above 800° C the acceleration of the gases and homogeneous nucleation of SiH₄ into solid polymers/crystallites, which are no longer able to react with the inlet walls, prevent deposition. Should a high growth rate be obtained, high temperatures in the susceptor is needed therefor, namely at least above 1500°C, but most preferred 2000-2500 °C, so that it will be impossible to avoid the reactive gases from entering within said temperature range inside the first conduit, and in the embodiment shown in Fig. 2 this will result in a deposition ring 30 as illustrated in Fig. 3. This deposition ring will be located a few millimetres above the end of the second conduit 25. This deposition, which in the case of SiH₄ gas is due to deposition of polycrystalline Si, eventually leads to a blocking of the first conduit there, especially if very high growth rates and high temperatures are chosen, which is a necessity for producing SiC crystals in a commercially interesting way.

It is schematically illustrated in Fig. 4 how the first conduit may be modified in the region 31 where the second conduit emerges into the first one for solving this problem. More exactly, the cross-section of the first conduit is enlarged in this region and the inner walls thereof converges in the downstream direction, so that a portion 32 of the first conduit is substantially cone-shaped. This portion is followed by a substantially cylindrical portion 33. This means that the deposition ring 30 will be located in a part of the first conduit where the cross-section is large and by that the deposition rate is slowest and harmless. The decreasing cross-section of the first conduit in this region will also result in an acceleration of the carrier gas flow, so that this will force the reactive species back to the centre of the first conduit and thus reducing the building of the deposition ring. Downstream of said deposition ring the temperature will be above the deposition temperature range. Due to the acceleration of the gases lower Si supersaturation and homogeneous nucleation of Si related species in the gas-phase into solid polymers/particles is achieved. The solid polymers/particles are no longer able to react with the inlet walls. Thus, there will be no parasitic deposition any longer.

A device according to another embodiment of the invention is illustrated in Fig. 5. The same references as in the previous figures are used for corresponding elements. It is illustrated how an inlet flange 26 forming the first conduit is provided with water-cooling means 34 for cooling the first conduit, so that the temperature of the carrier gas flow therein and by that the temperature of the reactive gases in the second conduit is kept at an acceptable level. Furthermore, either the thickness of the converging portion 32 of the first conduit may be varied or the portion 32 may be made in two graphite parts 35, 41 with differing thermal conductivity, so that the temperature gradient from the watercooled stainless steel portion 36 to the graphite of the portion 35 (primarily heated by conduction and radiation from the graphite susceptor 7 placed further above) will be very steep, so that the reactive gases are violently heated when emerging from the second conduit, so that they are accelerated by free convection and pass the critical temperature zone (500-800°C for SiH₄) as fast as possible. Furthermore, the presence of a steep temperature gradient makes it possible to define this critical zone as being graphite located just thereabove, so that it is ensured that inevitable depositions occur in the wide cross-section part of the converging inlet where it is harmless.

Fig. 6 illustrates a further possibility to design the first conduit close to the opening into the susceptor room 18, and a portion 37 of the first conduit close to the susceptor room diverges towards said room, so that a diffuser-like inlet is created and by that the gases entering the susceptor room will be spread towards the circumferential walls thereof, which may be suitable, in particular in a device of the type shown in Fig. 7.

The device according to Fig. 7 is a so-called chimney reactor, which has an outlet 38 located centrally opposite to the inlet, and vertical walls 39 of the susceptor are arranged to carry substrates 40 for epitaxial growth of SiC thereon. The cross-section of the room may in this case be rectangular. It is in this way possible to increase the capacity of the susceptor and grow more than one object at the time, and higher growth rates may be obtained due to a geometry suitable for increased temperatures and with low carrier gas flows.

As already mentioned, the invention is also applicable to the growth of a Group III-nitride or an alloy of Group III-nitrides or an alloy of SiC and one or more Group III-nitrides, for which the corresponding positive result may be expected. As an example, it may be mentioned that Tri-Methyl-Gallium may be used as a precursor gas for the growth of GaN.

The definition "objects" in the claims is made for including the epitaxial growth of all types of crystals, such as layers of different thicknesses as well as thick boules.

All definitions concerning the material of course also include inevitable impurities as well as intentional doping.

Although it has been indicated in the figures that the flow of gases to the substrate is substantially vertical, it is within the scope of the invention to arrange the device with an arbitrary extension direction, such as for instance horizontal.

## Claims

1. A device for epitaxially growing objects of one of a) SiC, b) a Group III-nitride and c) alloys thereof by Chemical Vapour Deposition on a substrate comprising a susceptor (7) having circumferential walls (8) surrounding a room (18) for receiving the substrate, means for feeding a flow of at least a carrier gas and reactive gases needed for the growth into the susceptor towards the substrate and means for heating said circumferential walls and the substrate and said reactive gases above a temperature level from which the reactive gases start to decompose into substances depositing on the substrate for the growth of a said object, said feeding means comprising a conduit emerging into said room, **characterized in that** said feeding means further comprises an additional second conduit (25) received in the first-mentioned, first conduit (24), having a smaller cross-section than the first conduit and extending in the longitudinal direction of the first conduit with a circumferential space separating it from inner walls of the first conduit, that said feeding means is adapted to make the first conduit to conduct substantially only a carrier gas and the second conduit to conduct substantially the entire flow of reactive gases, and that said second conduit ends, as seen in the direction of said flows, and emerges into said first conduit in region (31) at a distance from said room said distance is chosen so that said reactive gases will not reach such a high temperature inside the second conduit that they will decompose therein and that said first conduit (24) has inner walls (32) converging from said region in the direction of said room (18).

2. A device according to claim 1, **characterized in that** the first conduit (24) has a cross-section being enlarged in the region (31) where the second conduit emerges into the first conduit.

3. A device according to claim 1, **characterized in that** the first conduit (24) is substantially cone-shaped from said region (31) and in the direction of said room (18).

4. A device according to any of claims 1-3, **characterized in that** the first conduit (24) has a cross-section decreasing from said region (31) in the direction of the room to a first location upstream of said room and from said location to the room a substantially constant cross-section.

5. A device according to any of claims 1-4, **characterized in that** the cross-section of the first conduit increases from a second location downstream (37) of said region (31) and to said room (18).

6. A device according to any of claims 1-5, **characterized in that** it comprises means (34) adapted to cool the inner walls of a first wall portion of said first conduit next to said region (31) upstream thereof, and that wall portions of the first conduit downstream of the first wall portion are made of a material with a thermal conductivity utilizing heat transfer from the heated susceptor for obtaining a temperature gradient along walls of the first conduit in said region being as steep as possible.

7. A device according to claim 6, **characterized in that** the first conduit (24) comprises at least two succeeding parts with differing thermal conductivities.

8. A device according to any of claims 1-7, **characterized in that** said first (24) and second (25) conduits are concentrically arranged with respect to each other, at least close to said room.

9. A device according to any of claims 1-8, **characterized in that** said second, inner conduit (25) is made of SiC, Tantalum or Tungsten.

10. A device according to any of claims 1-9, **characterized in that** said conduits have a substantially vertical extension, a substantially vertical wall (39) of said room (18) is adapted to carry said substrate (40), and said room has a gas outlet (38) arranged in the ceiling thereof substantially opposite to the inlet.

11. A device according to claim 10, **characterized in that** the walls (39) of the room are adapted to carry a plurality of substrates (40) for growth of objects thereon.

12. A device according to any of claims 1-11, **characterized in that** it is adapted for growth of objects of SiC.

13. A device according to claim 12, **characterized in that** said heating means is arranged to heat said circumferential walls (8) and by that the substrate and said reactive gases at a temperature above 1500°C.

14. A device according to claim 13, **characterized in that** said heating means is arranged to heat said circumferential walls and by that the substrate and said reactive gases at a temperature above 2000°C.

15. A device according to any of claims 12-14, **characterized in that** said heating means is arranged to heat the reactive gases so that the temperature thereof rises above 500°C after entering the first conduit (24) but before entering the room (18).

16. A device according to claim 15, **characterized in that** said heating means is arranged to heat the reactive gases so that the temperature thereof rises above 500°C in the portion (32) of the first conduit with a decreasing cross-section in the most upstream part of this portion.

17. A device according to any of claims 12-16, **characterized in that** said feeding means is arranged to feed silane or chlorosilanes as a silicon precursor and propane, methane or ethylene as a carbon precursor in concentrated or diluted form.

18. A method for epitaxially growing objects of one of a) SiC, b) a Group III-nitride and c) alloys thereof by Chemical Vapour Deposition on a substrate received in a room (18) of a susceptor (7) having circumferential walls (8), in which a flow of at least a carrier gas and reactive gases needed for the growth is fed into said room towards the substrate; said circumferential walls, the substrate and said reactive gases are heated above a temperature level from which the reactive gases start to decompose into substances depositing on the substrate for the growth of a said object, **characterized in that** a flow of substantially only a carrier gas is fed to said room in a first conduit (24) and substantially the entire flow of reactive gases is fed to the susceptor in a second conduit (25) received in the first conduit, having a smaller cross-section than the first conduit and extending in the longitudinal direction of the first conduit with a circumferential space separating it from the inner walls of the first conduit, **in that** way that said flow inside the second conduit emerges into said first conduit at a distance from the room so that said reactive gases will not reach such a high temperature inside the second conduit that they will decompose therein.

19. A method according to claim 18, **characterized in that** the carrier gas is in a region (31) of the first conduit (24) where the second conduit emerges into the first conduit guided in a path with a decreasing cross-section closer to the centre of the first conduit for accelerating the flow of the carrier gas in this region.

20. A method according to claim 19, **characterized in that** the inner wall (36) of the first conduit located upstream of a location in said region (31) is cooled, and that the inner wall portions located upstream of this location and those located downstream thereof are thermally insulated with respect to each other for obtaining a steep temperature gradient at this location in said region.

21. A method according to any of claims 18-20, **characterized in that** SiC is epitaxially grown on the substrate and silane and propane are fed as reactive gases in said second conduit (25).

22. A method according to claim 21, **characterized in that** helium, argon or a blend thereof is fed as a carrier gas in the first conduit (24).

23. A method according to claim 21 or 22, **characterized in that** the heating of the reactive gases is carried out so that the temperature level as of which the silocon precursor may decompose and deposit on surfaces is passed in the region (31) where the second conduit emerges into the first conduit well downstream of the end of the second conduit.

24. A method according to claim 23, **characterized in that** said heating of the reactive gases is carried out so that a temperature of 500°C thereof is passed in the first conduit substantially immediately downstream the end of the second conduit.

25. A method according to any of claims 18-24, **characterized in that** the carrier gas is fed in said first conduit (24) with substantially the same velocity as that of the flow of reactive gases in said second conduit (25).

26. A method according to any of claims 18-25, **characterized in that** the carrier gas flow and the flow of reactive gases are fed so that the flow of reactive gases emerges into said first conduit (24) substantially concentrically thereto.

27. A method according to any of claims 21-24, **characterized in that** said circumferential walls (8) are heated above 1500°C.

28. A method according to claim 27, **characterized in that** said circumferential walls (8) are heated above 2000°C.

29. A method according to any of claims 18-28, **characterized in that** the reactive gases are conducted into said room (18) to one or more substrates (40) located on substantially vertical inner walls (39) of the room for growth of an object thereon substantially in the horizontal direction.

## Patentansprüche

1. Vorrichtung zum epitaxialen Aufwachsen von Objekten auf einem von a) SiC, b) einem Nitrid der Gruppe III und c) Legierungen davon durch chemisches Aufdampfen auf ein Substrat, wobei die Vorrichtung folgendes aufweist: einen Sekundärzylinder (7), der Umfangswandungen (8) hat, die einen Raum (18) zur Aufnahme des Substrats umgeben, eine Einrichtung zum Zuführen eines Stroms aus mindestens einem Trägergas und reaktionsfähigen Gasen, die für das Aufwachsen notwendig sind, in den Sekundärzylinder in Richtung zu dem Substrat, und eine Einrichtung zum Erwärmen der Umfangswandungen und des Substrats und der reaktionsfähigen Gase über ein Temperaturniveau, von dem aus die reaktionsfähigen Gase beginnen, sich in Substanzen zu zersetzen, die sich auf dem Substrat zum Aufwachsen eines genannten Objekts absetzen, wobei die Zuführeinrichtung eine Leitung aufweist, die in den genannten Raum austritt, **dadurch gekennzeichnet, daß** die Zuführeinrichtung ferner eine zusätzliche zweite Leitung (25) aufweist, die in der erstgenannten ersten Leitung (24) aufgenommen ist, einen kleineren Querschnitt als die erste Leitung hat und in der Längsrichtung der ersten Leitung mit einem umfangsmäßigen Abstand verläuft, der sie von Innenwandungen der ersten Leitung trennt, daß die Zuführeinrichtung so ausgebildet ist, daß die erste Leitung im wesentlichen nur ein Trägergas führen kann und die zweite Leitung im wesentlichen den Gesamtstrom von reaktionsfähigen Gasen führen kann, und daß die zweite Leitung - in Richtung der genannten Ströme gesehen - in einer Distanz von dem genannten Raum endet und in die erste Leitung in einem Bereich (31) eintritt, wobei die Distanz so gewählt ist, daß die reaktionsfähigen Gase keine so hohe Temperatur im Inneren der zweiten Leitung erreichen, daß sie sich darin zersetzen, und daß die erste Leitung (24) Innenwandungen (32) hat, die von dem genannten Bereich in Richtung zu dem Raum (18) konvergieren.

2. Vorrichtung nach Anspruch 1, **dadurch gekennzeichnet, daß** die erste Leitung (24) einen Querschnitt hat, der in dem Bereich (31), in dem die zweite Leitung in die erste Leitung austritt, vergrößert ist.

3. Vorrichtung nach Anspruch 1, **dadurch gekennzeichnet, daß** die erste Leitung (24) ausgehend von dem Bereich (31) und in Richtung zu dem Raum (18) im wesentlichen konusförmig ist.

4. Vorrichtung nach einem der Ansprüche 1 bis 3, **dadurch gekennzeichnet, daß** die erste Leitung (24) einen Querschnitt hat, der ausgehend von dem Bereich (31) in Richtung des Raums bis zu einer ersten Stelle an der Aufstromseite des Raums abnimmt, und daß sie ausgehend von dieser Stelle bis zu dem Raum einen im wesentlichen konstanten Querschnitt hat.

5. Vorrichtung nach einem der Ansprüche 1 bis 4, **dadurch gekennzeichnet, daß** der Querschnitt der ersten Leitung von einer zweiten Stelle an der Abstromseite (37) des Bereichs (31) und zu dem Raum (18) zunimmt.

6. Vorrichtung nach einem der Ansprüche 1 bis 5, **dadurch gekennzeichnet, daß** sie eine Einrichtung (34) aufweist, die so ausgebildet ist, daß sie die Innenwandungen eines ersten Wandbereichs der ersten Leitung nahe dem Bereich (31) an der Aufstromseite davon kühlt, und daß Wandbereiche der ersten Leitung an der Abstromseite des ersten Wandbereichs aus einem Material mit einer Wärmeleitfähigkeit bestehen, die die Wärmeübertragung von dem erwärmten Sekundärzylinder nutzt, um einen Temperaturgradienten entlang Wandungen der ersten Leitung in dem genannten Bereich zu erzielen, wobei der Temperaturgradient so steil wie möglich ist.

7. Vorrichtung nach Anspruch 6, **dadurch gekennzeichnet, daß** die erste Leitung (24) mindestens zwei aufeinanderfolgende Teile mit unterschiedlicher Wärmeleitfähigkeit aufweist.

8. Vorrichtung nach einem der Ansprüche 1 bis 7, **dadurch gekennzeichnet, daß** die erste (24) und die zweite (25) Leitung in bezug aufeinander zumindest nahe dem genannten Raum konzentrisch angeordnet sind.

9. Vorrichtung nach einem der Ansprüche 1 bis 8, **dadurch gekennzeichnet, daß** die zweite, innere Leitung (25) aus Sic, Tantal oder Wolfram besteht.

10. Vorrichtung nach einem der Ansprüche 1 bis 9, **dadurch gekennzeichnet, daß** die Leitungen eine im wesentlichen vertikale Erstreckung haben, eine im wesentlichen vertikale Wand (29) des Raums (18) zum Tragen des Substrats (40) ausgebildet ist, und der Raum einen Gasauslaß (38) hat, der in seiner Decke im wesentlichen dem Einlaß gegenüberliegend angeordnet ist.

11. Vorrichtung nach Anspruch 10, **dadurch gekennzeichnet, daß** die Wände (39) des Raums so ausgebildet sind, daß sie eine Vielzahl von Substraten (40) tragen, um Objekte darauf aufwachsen zu lassen.

12. Vorrichtung nach einem der Ansprüche 1 bis 11, **dadurch gekennzeichnet, daß** sie zum Aufwachsen von Objekten aus SiC ausgebildet ist.

13. Vorrichtung nach Anspruch 12, **dadurch gekennzeichnet, daß** die Heizeinrichtung so angeordnet ist, daß sie die Umfangswandungen (8) und dadurch das Substrat und die reaktionsfähigen Gase auf eine Temperatur oberhalb 1500 °C erwärmt.

14. Vorrichtung nach Anspruch 13, **dadurch gekennzeichnet, daß** die Heizeinrichtung so angeordnet ist, daß sie die Umfangswandungen und dadurch das Substrat und die reaktionsfähigen Gase auf eine Temperatur oberhalb 2000 °C erwärmt.

15. Vorrichtung nach einem der Ansprüche 12 bis 14, **dadurch gekennzeichnet, daß** die Heizeinrichtung so angeordnet ist, daß sie die reaktionsfähigen Gase so erwärmt, daß deren Temperatur nach dem Eintritt in die erste Leitung (24), jedoch vor dem Eintritt in den Raum (18) über 500 °C ansteigt.

16. Vorrichtung nach Anspruch 15, **dadurch gekennzeichnet, daß** die Heizeinrichtung so angeordnet ist, daß sie die reaktionsfähigen Gase so erwärmt, daß deren Temperatur in dem Bereich (32) der ersten Leitung mit abnehmendem Querschnitt in dem am weitesten aufstromseitigen Teil dieses Bereichs über 500 °C ansteigt.

17. Vorrichtung nach einem der Ansprüche 12 bis 16, **dadurch gekennzeichnet, daß** die Zuführeinrichtung so angeordnet ist, daß sie Silan oder Chlorsilane als Siliciumvorstufe und Propan, Methan oder Ethylen als Kohlenstoffvorstufe in konzentrierter oder verdünnter Form zuführt.

18. Verfahren zum epitaxialen Aufwachsen von Objekten auf eines von a) SiC, b) ein Nitrid der Gruppe III und c) Legierungen davon durch chemisches Aufdampfen auf ein Substrat, das in einem Raum (18) eines Sekundärzylinders (7) aufgenommen ist, der Umfangswandungen (8) hat, wobei ein Strom aus mindestens einem Trägergas und für das Aufwachsen notwendigen reaktionsfähigen Gasen in den Raum zu dem Substrat hin zugeführt wird, wobei die Umfangswandungen, das Substrat und die reaktionsfähigen Gase über ein Temperaturniveau erwärmt werden, von dem aus die reaktionsfähigen Gase beginnen, in Substanzen zu zerfallen, die sich auf dem Substrat für das Aufwachsen eines genannten Objekts absetzen, **dadurch gekennzeichnet, daß** ein Strom von im wesentlichen nur einem Trägergas dem Raum in einer ersten Leitung (24) zugeführt wird und im wesentlichen der gesamte Strom von reaktionsfähigen Gasen dem Sekundärzylinder in einer zweiten Leitung (25) zugeführt wird, die in der ersten Leitung aufgenommen ist, kleineren Querschnitt als die erste Leitung hat und in der Längsrichtung der ersten Leitung mit einem umfangsmäßigen Abstand verläuft, der sie von den Innenwandungen der ersten Leitung trennt, derart, daß der Strom im Inneren der zweiten Leitung in einer Distanz von dem Raum in die zweite Leitung austritt, so daß die reaktionsfähigen Gase im Inneren der zweiten Leitung keine so hohe Temperatur erreichen, daß sie sich darin zersetzen.

19. Verfahren nach Anspruch 18, **dadurch gekennzeichnet, daß** das Trägergas in einem Bereich (31) der ersten Leitung (24) ist, in dem die zweite Leitung in die erste Leitung unter Führung in einer Bahn mit abnehmendem Querschnitt näher an der Mitte der ersten Leitung austritt, um den Durchfluß des Trägergases in diesem Bereich zu beschleunigen.

20. Verfahren nach Anspruch 19, **dadurch gekennzeichnet, daß** die Innenwand (36) der ersten Leitung, die an der Aufstromseite einer Stelle in dem genannten Bereich (31) liegt, gekühlt wird, und daß die Innenwandbereiche, die sich an der Aufstromseite dieser Stelle befinden, und diejenigen, die sich an der Abstromseite davon befinden, in bezug aufeinander wärmegedämmt sind, um an dieser Stelle in dem genannten Bereich einen steilen Temperaturgradienten zu erzielen.

21. Verfahren nach einem der Ansprüche 18 bis 20, **dadurch gekennzeichnet, daß** man SiC epitaxial auf dem Substrat aufwachsen läßt und Silan und Propan als reaktionsfähige Gase in der zweiten Leitung (25) zugeführt werden.

22. Verfahren nach Anspruch 21, **dadurch gekennzeichnet, daß** Helium, Argon oder ein Gemisch daraus als Trägergas in der ersten Leitung (24) zugeführt wird.

23. Verfahren nach Anspruch 21 oder 22, **dadurch gekennzeichnet, daß** die Erwärmung der reaktionsfähigen Gase so durchgeführt wird, daß das Temperaturniveau, von dem aus der Siliciumvorläufer sich zersetzen und auf Oberflächen absetzen kann, in dem Bereich (31), in dem die zweite Leitung in die erste Leitung austritt, weit abstromseitig von dem Ende der zweiten Leitung passiert wird.

24. Verfahren nach Anspruch 23, **dadurch gekennzeichnet, daß** das Erwärmen der reaktonsfähigen Gase so durchgeführt wird, daß eine Temperatur von 500 °C der Gase in der ersten Leitung im wesentlichen unmittelbar abstromseitig von dem Ende der zweiten Leitung passiert wird.

25. Verfahren nach einem der Ansprüche 18 bis 24, **dadurch gekennzeichnet, daß** das Trägergas in die erste Leitung (24) im wesentlichen mit der gleichen Geschwindigkeit wie diejenige des Stroms von reaktionsfähigen Gasen in der zweiten Leitung (25) zugeführt wird.

26. Verfahren nach einem der Ansprüche 18 bis 25, **dadurch gekennzeichnet, daß** der Trägergasstrom und der Strom von reaktionsfähigen Gasen so zugeführt werden, daß der Strom von reaktionsfähigen Gasen in die erste Leitung (24) im wesentlichen konzentrisch dazu austritt.

27. Verfahren nach einem der Ansprüche 21 bis 24, **dadurch gekennzeichnet, daß** die Umfangswandungen (8) über 1500 °C erwärmt werden.

28. Verfahren nach Anspruch 27, **dadurch gekennzeichnet, daß** die Umfangswandungen (8) über 2000 °C erwärmt werden.

29. Verfahren nach einem der Ansprüche 18 bis 28, **dadurch gekennzeichnet, daß** die reaktionsfähigen Gase in den Raum (18) auf eines oder mehrere Substrate (40) geleitet werden, die an im wesentlichen vertikalen Innenwandungen (39) des Raums angeordnet sind, um ein Objekt darauf im wesentlichen in der Horizontalrichtung aufwachsen zu lassen.

## Revendications

1. Dispositif pour faire croître de manière épitaxiale des objets constitués d'un élément parmi a) SiC, b) un nitrure du groupe III et c) des alliages de ceux-ci par Dépôt Chimique en Phase Vapeur sur un substrat comportant un suscepteur (7) ayant des parois circonférentielles (8) entourant une chambre (18) destinée à recevoir le substrat, des moyens pour alimenter un écoulement d'au moins un gaz porteur et de gaz réactifs nécessaires pour la croissance dans le suscepteur en direction du substrat et des moyens pour chauffer lesdites parois circonférentielles et le substrat et lesdits gaz réactifs au-dessus d'un niveau de température à partir duquel les gaz réactifs commencent à se décomposer en substances se déposant sur le substrat pour la croissance dudit objet, lesdits moyens d'alimentation comportant une conduite émergeant dans ladite chambre, **caractérisé en ce que** lesdits moyens d'alimentation comportent de plus une seconde conduite supplémentaire (25) reçue dans la première conduite mentionnée ci-dessus (24), ayant une coupe transversale plus petite que la première conduite et s'étendant dans la direction longitudinale de la première conduite avec un espace circonférentiel la séparant des parois intérieures de la première conduite, **en ce que** lesdits moyens d'alimentation sont adaptés pour amener la première conduite à transporter essentiellement uniquement un gaz porteur et la seconde conduite à transporter essentiellement l'écoulement entier de gaz réactifs, et **en ce que** la seconde conduite se termine, comme observé dans la direction desdits écoulements, et émerge dans ladite première conduite dans une région (3) se trouvant à une distance par rapport à ladite chambre, ladite distance est choisie de sorte que lesdits gaz réactifs ne vont pas atteindre une température élevée à l'intérieur de la seconde conduite telle qu'ils vont se décomposer à l'intérieur, et que ladite première conduite (24) a des parois intérieures (32) convergeant depuis ladite région dans la direction de ladite chambre (18).

2. Dispositif selon la revendication 1, **caractérisé en ce que** la première conduite (24) a une coupe transversale qui est agrandie dans la région (31) où la seconde conduite émerge dans la première conduite.

3. Dispositif selon la revendication 1, **caractérisé en ce que** la première conduite (24) a une forme essentiellement en cône depuis ladite région (31) et dans la direction de ladite chambre (18).

4. Dispositif selon l'une quelconque des revendications 1 à 3, **caractérisé en ce que** la première conduite (24) a une coupe transversale diminuant depuis ladite région (31) dans la direction de la chambre jusqu'à un premier emplacement en amont de ladite chambre, et depuis ledit emplacement jusqu'à la chambre elle a une coupe transversale essentiellement constante.

5. Dispositif selon l'une quelconque des revendications 1 à 4, **caractérisé en ce que** la coupe transversale de la première conduite augmente depuis un second emplacement (37) en aval de ladite région (31) et jusqu'à ladite chambre (18).

6. Dispositif selon l'une quelconque des revendications 1 à 5, **caractérisé en ce qu'**il comporte des moyens (34) adaptés pour refroidir les parois intérieures d'une première partie de paroi de ladite première conduite après ladite région (31) en amont de celle-ci, et **en ce que** des parties de paroi de la première conduite en aval de la première partie de paroi sont constituées d'un matériau ayant une conductivité thermique utilisant un transfert thermique depuis le suscepteur chauffé pour obtenir un gradient de température le long de parois de la première conduite dans ladite région le plus raide possible.

7. Dispositif selon la revendication 6, **caractérisé en ce que** la première conduite (24) comporte au moins deux parties successives ayant des conductivités thermiques différentes.

8. Dispositif selon l'une quelconque des revendications 1 à 7, **caractérisé en ce que** lesdites première (24) et seconde (25) conduites sont agencées de manière concentrique l'une par rapport à l'autre, au moins à proximité de ladite chambre.

9. Dispositif selon l'une quelconque des revendications 1 à 8, **caractérisé en ce que** ladite seconde conduite intérieure (25) est constituée de SiC, de Tantale ou de Tungstène.

10. Dispositif selon l'une quelconque des revendications 1 à 9, **caractérisé en ce que** lesdites conduites ont un prolongement essentiellement vertical, une paroi essentiellement verticale (39) de ladite chambre (18) est adaptée pour supporter ledit substrat (40), et ladite chambre a une sortie gazeuse (38) agencée dans le plafond de celle-ci de manière essentiellement opposée à l'entrée.

11. Dispositif selon la revendication 10, **caractérisé en ce** les parois (39) de la chambre sont adaptées pour supporter une pluralité de substrats (40) afin de mettre en croissance les objets dessus.

12. Dispositif selon l'une quelconque des revendications 1 à 11, **caractérisé en ce qu'**il est adapté pour mettre en croissance des objets constitués de SiC.

13. Dispositif selon la revendication 12, **caractérisé en ce que** lesdits moyens de chauffage sont conçus pour chauffer lesdites parois circonférentielles (8) et le substrat et lesdits gaz réactifs à une température au-dessus de 1500°C.

14. Dispositif selon la revendication 13, **caractérisé en ce que** lesdits moyens de chauffage sont conçus pour chauffer lesdites parois circonférentielles et le substrat et lesdits gaz réactifs à une température au-dessus de 2000°C.

15. Dispositif selon l'une quelconque des revendications 12 à 14, **caractérisé en ce que** lesdits moyens de chauffage sont conçus pour chauffer les gaz réactifs de sorte que la température de ceux-ci augmente au-dessus de 500°C après être entrés dans la première conduite (24) mais avant d'entrer dans la chambre (18).

16. Dispositif selon la revendication 15, **caractérisé en ce que** lesdits moyens de chauffage sont conçus pour chauffer les gaz réactifs de sorte que la température de ceux-ci augmente au-dessus de 500°C dans la partie (32) de la première conduite ayant une coupe transversale décroissante dans la section la plus en amont de cette partie.

17. Dispositif selon l'une quelconque des revendications 12 à 16, **caractérisé en ce que** lesdits moyens d'alimentation sont conçus pour alimenter du silane ou des chlorosilanes en tant que précurseur de silicium et du propane, méthane ou éthylène en tant que précurseur de carbone sous une forme concentrée ou diluée.

18. Procédé pour mettre en croissance des objets constitués d'un élément parmi a) SiC, b) un nitrure du Groupe III et c) des alliages de ceux-ci par Dépôt Chimique en Phase Vapeur sur un substrat reçu dans une chambre (18) d'un suscepteur (7) ayant des parois circonférentielles (8), dans lequel un écoulement d'au moins un gaz porteur et de gaz réactifs nécessaires pour la croissance est alimenté dans ladite chambre en direction du substrat, et lesdites parois circonférentielles, le substrat et lesdits gaz réactifs sont chauffés au-dessus d'un niveau de température à partir duquel les gaz réactifs commencent à se décomposer en substances se déposant sur le substrat pour la croissance dudit objet, **caractérisé en ce qu'**un écoulement constitué essentiellement uniquement d'un gaz porteur est alimenté dans ladite chambre dans une première conduite (24) et essentiellement l'écoulement entier de gaz réactifs est alimenté dans le suscepteur dans une seconde conduite (25) reçue dans la première conduite, ayant une coupe transversale plus petite que la première conduite et s'étendant dans la direction longitudinale de la première conduite avec un espace circonférentiel la séparant des parois intérieures de la première conduite, **en ce que** ledit écoulement à l'intérieur de la seconde conduite émerge dans ladite première conduite à une distance par rapport à la chambre, de sorte que lesdits gaz réactifs ne vont pas atteindre une température élevée à l'intérieur de la seconde conduite telle qu'ils vont se décomposer à l'intérieur.

19. Procédé selon la revendication 18, **caractérisé en ce que** le gaz porteur se trouve dans une région (31) de la première conduite (24) où la seconde conduite émerge dans la première conduite guidée dans un trajet ayant une coupe transversale décroissante à proximité plus proche du centre de la première conduite pour accélérer l'écoulement du gaz porteur dans cette région.

20. Procédé selon la revendication 19, **caractérisé en ce que** la paroi intérieure (36) de la première conduite située en amont d'un emplacement dans ladite région (31) est refroidie, et **en ce que** les parties de paroi intérieures situées en amont de cet emplacement et celles situées en aval de celui-ci sont thermiquement isolées les unes par rapport aux autres pour obtenir un gradient de température raide à cet emplacement dans ladite région.

21. Procédé selon l'une quelconque des revendications 18 à 20, **caractérisé en ce que** SiC est mis en croissance de manière épitaxiale sur le substrat et du silane et du propane sont alimentés en tant que gaz réactifs dans ladite seconde conduite (25).

22. Procédé selon la revendication 21, **caractérisé en ce que** de l'hélium, de l'argon ou un mélange de ceux-ci est alimenté en tant que gaz porteur dans la première conduite (24).

23. Procédé selon la revendication 21 ou 22, **caractérisé en ce que** le chauffage des gaz réactifs est effectué de sorte que le niveau de température auquel le précurseur de silicium peut se décomposer et se déposer sur les surfaces est passé dans la région (31) où la seconde conduite émerge dans la première conduite bien en aval de l'extrémité de la seconde conduite.

24. Procédé selon la revendication 23, **caractérisé en ce que** ledit chauffage des gaz réactifs est effectué de sorte qu'une température de 500°C de ceux-ci est passée dans la première conduite de manière essentiellement immédiate en aval de l'extrémité de la seconde conduite.

25. Procédé selon l'une quelconque des revendications 18 à 24, **caractérisé en ce que** le gaz porteur est alimenté dans ladite première conduite (24) en ayant essentiellement la même vitesse que celle de l'écoulement des gaz réactifs dans ladite seconde conduite (25).

26. Procédé selon l'une quelconque des revendications 18 à 25, **caractérisé en ce que** ledit écoulement de gaz porteur et l'écoulement de gaz réactifs sont alimentés de sorte que l'écoulement de gaz réactifs émerge dans ladite première conduite (24) de manière essentiellement concentrique à celle-ci.

27. Procédé selon l'une quelconque des revendications 21 à 24, **caractérisé en ce que** lesdites parois circonférentielles (8) sont chauffées au-dessus de 1500°C.

28. Procédé selon la revendication 27, **caractérisé en ce que** lesdites parois circonférentielles (8) sont chauffées au-dessus de 2000°C.

29. Procédé selon l'une quelconque des revendications 18 à 28, **caractérisé en ce que** les gaz réactifs sont amenés dans ladite chambre (18) vers un ou plusieurs substrats (40) positionnés sur des parois intérieures essentiellement verticales (39) de la chambre pour une croissance d'un objet dessus essentiellement dans la direction horizontale.
